Europäisches Patentamt

European Patent Office

Office européen des brevets

(19)

(11) Numéro de publication: **0 025 751**
**B1**

(12) **FASCICULE DE BREVET EUROPEEN**

(45) Date de publication du fascicule du brevet: **22.12.82**

(51) Int. Cl.³: **H 01 L 41/18**

(21) Numéro de dépôt: **80401271.4**

(22) Date de dépôt: **05.09.80**

(54) **Film de matériau composite piézo-électrique, et son procédé de fabrication.**

(30) Priorité: **14.09.79 FR 7922984**

(43) Date de publication de la demande:
**25.03.81 Bulletin 81/12**

(45) Mention de la délivrance du brevet:
**22.12.82 Bulletin 82/51**

(84) Etats contractants désignés:
**DE NL SE**

(56) Documents cités:
**FR - A - 2 117 315**

(73) Titulaire: **THOMSON-CSF**
**173, Boulevard Haussmann**
**F-75379 Paris Cedex 08 (FR)**

(72) Inventeur: **Micheron, François**
**"THOMSON-CSF" SCPI 173, bld Haussmann**
**F-75360 Paris Cedex 08 (FR)**

(74) Mandataire: **Lepercque, Jean et al,**
**THOMSON-CSF SCPI 173, Bld Haussmann**
**F-75379 Paris Cedex 08 (FR)**

Courier Press, Leamington Spa, England.

## Film de matériau composite piézoélectrique, et son procédé de fabrication

La présente invention se rapporte à un matériau composite piézoélectrique et au procédé de fabrication permettant son obtention.

De nombreux matériaux présentent des propriétés piézoélectriques ou sont susceptibles de présenter de tels effets après un traitement approprié. Les matériaux piézoélectriques présentent également des propriétés pyroélectriques. On peut citer par exemple des céramiques ferroélectriques polarisées ou le quartz monocristallin. Plus récemment, sont apparus les polymères piézoélectriques. Ces derniers sont utilisés sous forme de films plans métallisés sur deux faces, qui ont été orientés mécaniquement ou non, et dans tous les cas polarisés par application d'un champ électrique intense (de l'ordre de 1 MV/cm), à température supérieure ou égale à la température ambiante. Grâce à ce traitement, les films en matériau polymère acquièrent des propriétés pyroélectrique et piézoélectriques permettant de les utiliser comme transducteurs. Comme application de ces films plans, on peut citer des capteurs de pression, de déplacement (microphone, hydrophone, jauge de contrainte, etc....) et de température (capteur pyroélectrique pour la détection d'intrus, pour l'imagerie infra-rouge). Il a été proposé d'utiliser ces matériaux, après thermoformage ou moulage selon des formes appropriées, pour la réalisation de membranes d'écouteur de haut-parleur ou de microphone. De tels dispositifs transducteurs sont décrits, par exemple, dans la demande de brevet français N° 77 34 589, déposée le 17 Novembre 1977 au nom de la Demanderesse et publiée sous le N° 2 409 654 et correspondant à la demande européenne publiée sous le N° 0 002 161.

Parmi les polymères utilisables à de telles fins, on peut citer à titre indicatif le polyfluorure de vinylidène (PVF$_2$), le polychlorure de vinyle (PVC), le polyfluorure de vinyle (PVF), ainsi que des copolymères par exemple de polytétrafluorure éthylène-polyfluorure de vinylydène (PTFE-PVF$_2$). Des films plans de ces polymères sont obtenus habituellement par extrusion — soufflage, calendrage, pressage ou évaporation de solvants. Il est cependant difficile d'obtenir des films de grande dimension.

Chaque matériau piézoélectrique présente une compliance mécanique et une permittivité diélectrique qui lui est propre, ce qui fait que ces deux paramètres sont fixés par le choix du matériau. Il est intéressant pour certaines applications, et notamment dans le cas des hydrophones, de disposer de matériaux piézoélectriques dont les coefficients précités satisfassent à des normes préétablies et puissent être fixés indépendamment l'un de l'autre. Ceci n'est pas toujours réalisable avec des matériaux homogènes, aussi il a été proposé des matériaux piézoélectriques composites. On peut par exemple, associer des matériaux céramiques piézoélectriques à du plastique.

Pour répondre à ces besoins, et pallier les inconvénients des matériaux utilisés dans l'art antérieur, l'invention propose un matériau composite susceptible de présenter des propriétés piézoélectriques et son procédé de fabrication après un traitement approprié. Ce matériau est constitué d'un tissu imprégné de polymère. Par ce procédé on peut produire, de façon généralement économique, des films piézoélectriques et pyroélectriques de grande dimension dont certains coefficients électriques et mécaniques peuvent être déterminés au préalable, ce de façon autonome.

L'invention a donc pour objet un matériau composite susceptible de présenter des propriétés piézoélectriques par induction d'une anisotropie électrique, se présentant sous la forme d'un film, principalement caractérisé en ce qu'il est armé d'au moins un couche d'un tissu imprégné de polymère susceptible de présenter des propriétés piézoélectriques par induction d'une anisotropie électrique, dans au moins une de ses régions.

L'invention a encore pour objet un procédé de fabrication d'un tel matériau.

L'invention sera mieux comprise et d'autres avantages apparaîtront à la lecture de la description ci-après et à l'examen des figures annexées parmi lesquelle:

— la figure 1 illustre un exemple de matériau piézoélectrique et pyroélectrique composite selon l'invention;

— les figures 2 à 4 illustrent schématiquement chacune une étape du procédé de fabrication d'un tel matériau.

— la figure 5 est un diagramme explicatif caractérisant la réponse en tension d'un matériau composite piézoélectrique soumis à des contraintes extérieures.

Il est tout d'abord utile, avant de décrire le matériau composite réalisé selon l'invention et son procédé de fabrication, de rappeler les principales propriétés des matériaux polymères. Ces matériaux peuvent se classer en deux groupes principaux: d'une part les polymères amorphes, d'autre part le polymères semi-cristallins. Un des exemples de polymères semi-cristallins est le PVF$_2$. Comme il est bien connu, la structure du polyfluorure de vinylidène (PVF$_2$) se compose de zones cristallines sphéroïdales contenues dans une phase amorphe. Les propriétés mécaniques macroscopiques sont celles d'un corps isotrope. Ce polymère présente des formes cristallines distinctes: $\alpha$ et $\beta$. La forme $\alpha$ est celle que l'on obtient à partir du polymère fondu à une température de l'ordre de 170°C ou après évaporation, à une température supérieure à environ 80°C, du PVF$_2$ en solution dans un solvant qui peut être par exemple le diméthyl-formamide (DMF). Les chaînes moléculaires s'enroulent en hélice et présentent un agencement des atomes de carbone, d'hydrogène et de fluor du $PVF_2$, tels que les moments électriques bipolaires se compensent l'un l'autre lorsque l'on progresse le long de la chaîne. La forme $\beta$ est moins stable que la forme $\alpha$ et est caractérisée par un chaîne en zigzag et par des moments électriques bipolaires dont les effets s'ajoutent. On obtient la forme $\beta$ en évaporant une solution de $PVF_2$ dans un solvant (par exemple le DMF) a une température inférieure à environ 70°C. Si l'on considère un petit élément volumique du matériau polymère, cet élément comprend donc un certain nombre de chaînes présentant une phase solide I fortement polaire (phase $\beta$). Si le matériau polymère n'a subi aucune contrainte après solidification, il est doté d'une bonne stabilité mécanique et, puisqu'il n'a pas été polarisé électriquement, on peut considérer que d'un point de vue macroscopique, il est électriquement isotrope. Il est également connu, que pour établir dans le polyfluorure de vinylidène ainsi que dans les autres polymères polaires des propriétés piézoélectriques et pyroélectriques, il faille soumettre ces matériaux à un étirement important (300 à 500 %) qui vise à convertir la phase II non polaire en phase I polaire. Cet étirement induit une anisotropie mécanique. Pour créer l'anisotropie électrique nécessaire à la manifestation des effets pyroélectriques et piézoélectriques, on soumet le matériau à un champ électrique intense de direction essentiellement orthogonale aux plans principaux de la feuille de matériau polymère. Ainsi traité, si on munit la feuille en matériau polymère d'électrodes sur chacune de ses faces, l'ensemble forme un élément transducteur qui produit une tension électrique proportionnelle lorsqu'on l'échauffe ou lorsqu'on le soumet à une contrainte extérieure, par exemple à une pression dans une direction orthogonale au plan de la feuille. A l'inverse, une tension électrique appliquée entre les électrodes engendre des déformations mécaniques proportionnelles, ce toujours dans la direction orthogonale au plan de la feuille. Pour certains matériaux polymères, il est possible d'omettre la phase d'étirement mécanique et d'induire une anisotropie dans le matériau par voie purement électrique, à une température supérieure à 80°C. Par exemple, le $PVF_2$ en phase non polaire est ainsi rendu pseudo-polaire (phase $\alpha_p$). Ce procédé doit aussi être utilisé pour les polymères amorphes tels que le polychlorure de vinyle (PVC) et le polyfluorure de vinyle (PVF).

Comme il a été rappelé, ces polymères sous forme de films sont utilisés pour réaliser des transducteurs de différents types. Il est cependant difficile d'obtenir des films de matériau polymère en grande surface par les procédés qui ont été également rappelés.

Tout au contraire, l'invention propose un matériau composite et son procédé de fabrication permettant l'obtention de films de ce matériau de grande surface. Pour ce faire, on imprégné de matériau polymère un tissu. Le tissu forme un support plan et son imprégnation par un matérieau polymère permet d'obtenir un film de même surface que celle du tissu utilisé. L'imprégnation du tissu, ou enduction, peut se faire selon deux approches: selon la première approche, le tissu est imprégné par trempage dans un bain de polymère fondu, généralement à une température comprise dans la gamme 170—180°C; selon la seconde approche l'imprégnation peut se faire à une température ambiante en utilisant une solution d'un polymère dans un solvant, par exemple du diméthyl-formamide ou du cyclohexanone.

Dans le cas des polymères semi-cristallins, tels que le polyfluorure de vinylidène ($PVF_2$) ou des copolymères obtenus par association de ce polymère avec, par exemple, du polytétrafluorure éthyléne (PTFE), il est nécessaire que la phase cristalline soit dans une phase polaire. C'est le cas pour le $PVF_2$-PTFE, dès que la concentration en PTFE dépasse 3 à 4 %. De même, le $PVF_2$ en solution dans le diméthyl formamide est dans la phase polaire $\beta$ lorsque la température d'évaporation du solvant est inférieure à 70°C. Lorsque le $PVF_2$ est obtenu à partir d'un bain fondu, la phase polaire est obtenue par étirement de 300 à 500 %, à une température inférieure ou égale à 70°C. On peut également obtenir une phase pseudo-polaire $\alpha_p$ par la seule application d'un champ électrique très intense (supérieur à 1MV/cm) à température supérieure ou égale à la température ambiante. Ce procédé est également utilisé pour les polymères amorphes.

Le choix du tissu sera déterminé par, d'une part, l'approche utilisée pour l'imprégnation et, d'autre part, par les propriétés mécaniques et électriques dont on souhaite doter le matériau composite obtenu par le procédé de l'invention.

En ce qui concerne le premier point, l'imprégnation d'un tissu selon la première approche limite le choix du tissu à ceux pouvant soutenir des températures élevées, ce qui exclut notamment certains tissus synthétiques. L'imprégnation selon la seconde approche exclut pour sa part les tissus dont la composition serait incompatible avec le solvant untilisé.

Le traitement visant à communiquer aux matériaux composites ainsi obtenus des propriétés piézoélectriques et pyroélectriques conditionnent également le choix du tissu support. En effet, la plupart des tissus ne sont pas susceptibles d'accepter des étirements de l'ordre de 300 à 500 % nécessaires à l'obtention d'une phase orientée mécaniquement. Dans ce cas, on utilise le procédé visant à induire des propriétés piézoélectriques et pyroélectriques par la seule application d'un champ électrique intense suivant une direction orthogonale au plan du tissu.

Certains tissus sont cependant susceptibles d'être étirés: il s'agit de tissus à texture élastique. On peut donner comme exemple non limitatif les tissus dits "stretch". On peut encore augmenter cette possibilité en traitant spécialement les fils constituent le tissu de façon à ce qu'ils soient entortillés sur eux-mêmes et susceptibles d'être étirés dans de grandes proportions.

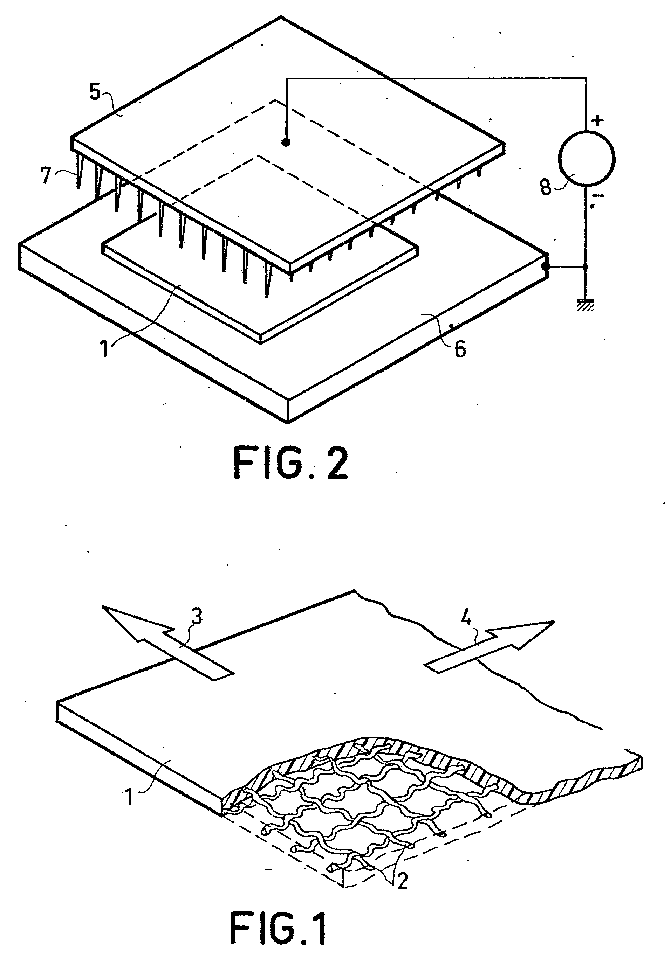

Un exemple d'un tel tissu est illustré schématiquement sur la figure 1 par la référence 2. Ce tissu est ensuite imprégné d'un polymère 1 pour former le matériau composite de l'invention. On peut étirer ensuite le film suivant une direction quelconque parallèle au plan de ce film et par exemple suivant les directions 3 ou 4 illustrées sur la figure. Il est à rappeler que les matériaux semi-cristalins comme le $PVF_2$ sont susceptibles d'acquérir une phase polaire de type $\beta$ par étirement.

A titre d'exemple, l'invention a été expérimentée dans deux cas voisins, ne différant que par la nature du tissu utilisé. Les deux tissus sont respectivement:

— une soie naturelle dont le pas de maille est environ de 100 $\mu m$;

— un tissu synthétique polyamide dont le pas de la maille est compris entre 200 et 300 $\mu m$.

Ces deux tissus ont été enduit d'une solu-tion de $PVF_2$ à saturation dans le diméthyl formamide. L'enduction a été effectuée par trempage du tissu dans la solution. La tension superficielle de la solution est suffisante pour que dans les deux cas, la solution comble les mailles. L'évaporation est obtenue à température ambiante, pendant 24 heures. On constate alors que le polyamide à larges mailles ne comporte alors que 95 % environ des mailles comblées par le polymére, alors que la soie présente moins de 1 % de défauts. Les deux échantillons ont été trempes à nouveau dans la même solution et séchés dans les mêmes conditions. Le remplissage des mailles est alors complet dans les deux cas.

Une fois le matériau composite obtenu, il doit être procédé dans tous les cas à une phase de polarisation électrique, de façon à ce que ces matériaux acquiérent par ce traitement les propriétés pyroélectriques et piézoélectriques souhaitées. Selon une première approche, cette polarisation peut s'effectuer par la méthode Corona, comme illustré sur la figure 2. Pour ce faire, le tissue imprégné 1 est tendu sur un plan métallique 6, relié au pôle négatif d'une source d'énergie de haute tension continue 8. Un ensemble de pointes métalliques 7 disposées en carré, sur des lignes et colonnes distantes de 2 cm et relié par une électrode métallique 5 au pôle positif de la source 8, est placé à 2 cm environ au-dessus du tissu imprégné 1. La tension utilisée est de l'ordre de 15 KV, appliquée pendant 5 minutes à température ambiante.

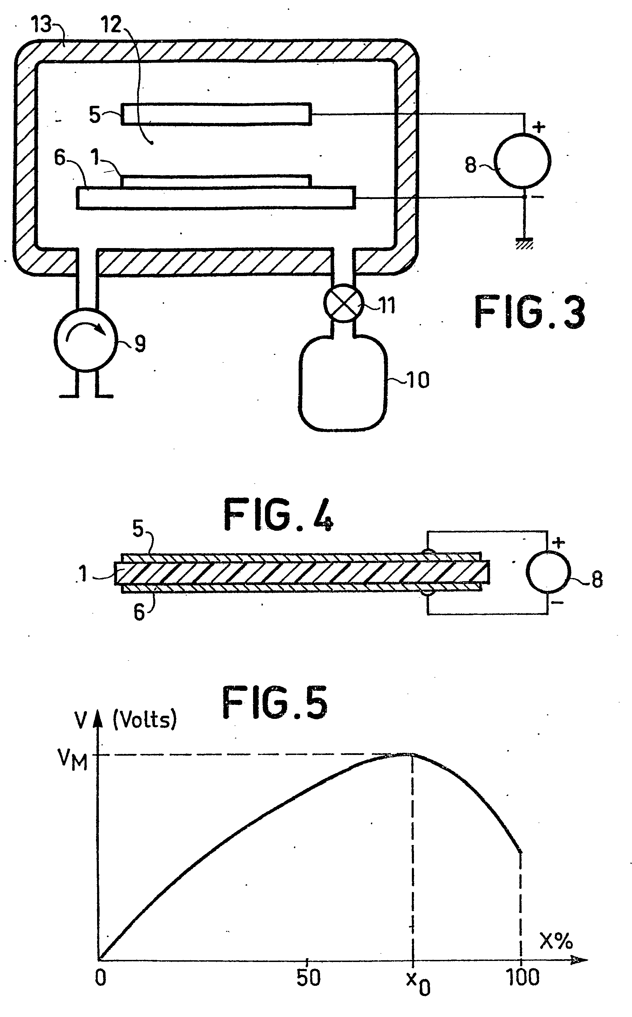

Selon une variante à cette approche, illustrée par la figure 3, les éléments de la figure 2, à savoir les électrodes 5 et 6 et le film de matériau composite 1 sont placés dans une enceinte 13 dans laquelle on abaisse lka pression à l'aide d'une pompe à vide 9. Un réservoir de gaz neutre 10 muni d'une valve de réglage 11 permet d'obtenir des conditions de décharge telles qu'il se forme un plasma entre l'électrode 5 et le film dans la région 12. On réalise ainsi dans cette région une électrode gazeuse.

Selon une deuxième approche, on métallise les deux faces principales du film 1 pour réaliser deux électrodes 5 et 6. Pour ce faire, on peut par exemple, appliquer une laque argentique sur ces deux faces. Les électrodes 5 et 6 sont reliées comme précédemment aux pôles positif et négatif d'une source de tension continue 8.

Cette polarisation peut également s'effectuer selon d'autres approches non représentées et, par exemple, en mettant en contact le film de matériau composite sur au moins l'une de ses faces avec une électrode liquide conductrice ou en plaçant le film entre deux électrodes planes appliquées par pression.

Le film de matériau composite de l'invention peut être mis en oeuvre dans différents transducteurs et par exemple être utilisé pour la réalisation d'un capteur de pression. A titre d'illustration de cette application, les échantillons précédemment décrits ont été métallisés sur les deux faces à l'aide d'une laque argentique à froid et les coefficients piézoélectriques mesurés. Le film placé sur un plan a été pressé à l'aide d'un poids connu et la charge électrique développée entre électrodes a été mesurée. Le coefficient piézoélectrique mesuré est: $d \simeq 8\ 10^{-13}\ C.N^{-1}$.

Bien que plus faible que le coefficient piézo-électrique du $PVF_2$ étiré et polarisé à chaud (coefficient piézoélectrique maximum), l'ordre de grandeur est suffisant pour que le matériau composite obtenu selon le procédé de l'invention puisse être exploité utilement comme transducteur piézoélectrique.

Comme il a été précédemment rappelé, un exemple d'application particulièrement avantageux des matériaux composites est l'utilisation de ce matériau pour réaliser des hydrophones.

Dans ce cas on a intérêt à déterminer à l'avance, de façon autonome, la compliance mécanique et la permittivité diélectrique du matériau utilisé pour la réalisation de tels dispositifs. Le matériau composite réalise selon l'invention permet cette détermination en dosant l'un par rapport à l'autre le pourcentage $x$ relatif de polymère par rapport au tissu. A titre d'illustration la figure 5 est un diagramme montrant l'évolution de la réponse en tension d'un matériau composite réalisé selon l'invention en fonction du pourcentage précité, ce pour une contrainte extérieure constante (par exemple une pression). On voit que la courbe passe par un maximum pour $x_0$.

L'invention n'est pas limitée aux exemples de réalisations qui viennent d'être décrits, le matériau composite de l'invention couvre tous les domaines d'application de la piézoélec-tricité et de la pyroélectricité, en particulier les dispositifs électroacoustiques, les émetteurs et récepteurs d'ultra-sons utilisés en acoustique sous-marine, des senseurs de rayonnement infra-rouge, les dispositifs d'inscription à jet d'encre, les dispositifs de mise à feu d'une charge explosif, les relais électriques et les filtres électromécaniques. A titre d'exemple non limitatif, certains de ces dispositifs ont été décrits dans la demande de brevet français N° 77 34 589, précitée.

Enfin le film matériau composite selon l'invention peut comprendre plus d'une couche de tissus ou n'être armé par le tissu que dans certaines régions déterminées, la partie restante du film n'étant constituée que de matériau polymère.

**Revendications**

1. Matériau composite susceptible de présenter des propriétés piézoélectriques par induction d'une anisotropie électrique, se présentant sous la forme d'un film caractérisé en ce qu'il est armé d'au moins une couche d'un tissu (2) imprégné de polymère (1) susceptible de présenter des propriétés piézoélectriques par induction d'une anisotropie électrique, dans au moins une de ses régions.

2. Matériau selon la revendication 1, caractérisé en ce que le tissu (2) est un tissu de texture susceptible de subir un étirement mécanique.

3. Matériau selon la revendication 1, caractérisé en ce que le polymère (1) est un polymère ou un copolymère semi-cristallin choisi parmi les suivants: polyfluorure de vinylidène, polyfluorure de vinylidène-polytétrafluorure éthylène, polyfluorure de vinylidène-polytrifluoroéthylène polyfluorure de vinylidène-polytrifluorochloroéthylène, polyfluorure de vinylidène-polytrichlorofluoroéthylène.

4. Matériau selon la revendication 1, caractérise en ce que le polymère (1) est un polymère amorphe choisi parmi les suivants: polychlorure de vinyle ou polyfluorure de vinyle.

5. Procédé de fabrication d'un matériau selon l'une quelconque des revendications 1 à 4, caractérisé en ce qu'il comprend une phase d'enduction d'au moins une couche de tissu par un polymère.

6. Procédé selon la revendication 5, caractérisé en ce que l'enduction s'effectue par au moins un trempage du tissu dans un bain de polymère en solution à saturation dans un solvant et en ce qu'il est procédé à une phase ultérieure d'évaporation du solvant.

7. Procédé selon la revendication 5, caractérisé en ce que l'enduction s'effectue à chaud par trempage du tissu dans un bain de polymère fondu.

8. Procédé selon l'une quelconque des revendications 5 à 7, caractérisé en ce qu'en outre il comprend une étape visant à communiquer au film de matériau composite situé entre deux électrodes (5, 6) des propriétés piézoélectriques et pyroélectriques en le soumettant à un champ électrique pendant un temps déterminé, les électrodes (5, 6) étant reliées à un générateur d'énergie électrique (8) délivrant une haute tension continue; le champ étant normal aux faces du film.

9. Procédé selon la revendication 8, caractérisé en ce que la polarisation électrique du film de matériau composite est obtenue au moyen d'une décharge Corona.

10. Procédé selon la revendication 8, caractérisé en ce que la polarisation électrique est obtenue en formant un plasma (12) par décharge sous pression réduite.

11. Procédé selon l'une quelconque des revendications 8 à 10, caractérisé en ce qu'au moins électrode est une électrode constituée par un liquide conducteur.

**Claims**

1. Composite material susceptible of showing piezoelectric properties by induction of an electric anisotropy, having the shape of a film, characterized in that it is reinforced by at least one layer of a tissue (2) impregnated by a polymer (1) susceptible of showing electric properties by induction of an electric anisotropy in at least one of its regions.

2. Material in accordance with claim 1, characterized in that the tissue (2) is a tissue having a texture susceptible of being mechanically stretched.

3. Material in accordance with claim 1, characterized in that the polymer (1) is a semicrystalline polymer or copolymer selected among the following: polyvinylidene fluoride, polyvinylidene fluoride-polytetrafluoroethylene, polyvinylidene fluoride-polytrifluoroethylene, polyvinylidene fluoride-polytrifluorochloroethylene, polyvinylidene fluoride-polytrichlorofluoroethylene.

4. Material in accordance with claim 1, characterized in that the polymer (1) is an amorphous polymer selected among the following: polyvinyl chloride, polyvinylfluoride.

5. Method of producing a material in accordance with any of claims 1 to 4, characterized in that it comprises a phase of coating at least one tissue layer by a polymer.

6. Method in accordance with claim 5, characterized in that the coating is performed by dipping the tissue at least once into a bath of a polymer in saturated solution in a solvent, and in that the solvent is evaporated in a subsequent phase.

7. Method in accordance with claim 5, characterized in that the coating is performed in a hot condition by dipping the tissue into a bath of a molten polymer.

8. Method in accordance with any of claims 5 to 7, characterized in that it further comprises a step adapted to give the film of composite material located between two electrodes (5, 6) piezoelectric and pyroelectric properties, by submitting it to an electric field during a predetermined time, the electrodes (5, 6) being connected to an electric energy generator (8) supplying a direct high voltage; the field being normal to the film faces.

9. Method in accordance with claim 8, characterized in that the electric polarization of the composite material film is obtained by means of a Corona discharge.

10. Method in accordance with claim 8, characterized in that the electric polarization is obtained by forming a plasma (12) by discharge at reduced pressure.

11. Method in accordance with any of claims 8 to 10, characterized in that at least one electrode is an electrode formed by a conducting liquid.

**Patentansprüche**

1. Zusammengesetztes Material, das durch Einführung einer elektrischen Anisotropie piezoelektrische Eigenschaften aufweisen kann und die Form eines Films aufweist, dadurch gekennzeichnet, daß es armiert ist mit wenigstens einer Lage eines Stoffes (2), der mit einem Polymerisat (1) imprägniert ist, das durch Einführung einer elektrischen Anisotropie wenigstens in einem seiner Gebiete elektrische Eigenschaften aufweisen kann.

2. Material nach Anspruch 1, dadurch gekennzeichnet, daß der Stoff (2) eine solche Textur aufweist, daß et mechanisch gedehnt werden kann.

3. Material nach Anspruch 1, dadurch gekennzeichnet, daß das Polymerisat (1) ein halbkristallines Polymerisat oder Copolymer ist, das unter den folgenden ausgewählt ist; Polyvinylidenfluorid, Polyvinylidenfluorid-Polytetrafluoräthylen, Polyvinylidenfluorid-Polytrifluoräthylen, Polyvinylidenfluorid-Polytrifluoräthylen, Polyvinylidenfluorid-Polytrifluorchloräthylen, Polyvinylidenfluorid-Polytrichlorfluoräthylen.

4. Material nach Anspruch 1, dadurch gekennzeichnet, daß das Polymerisat (1) ein amorphes Polymerisat ist, das unter den folgenden ausgewählt ist; Polyvinylchlorid, Polyvinylfluorid.

5. Verfahren zur Herstellung eines Materials nach einem der Ansprüche 1 bis 4, dadurch gekennzeichnet, daß es eine Phase der Beschichtung wenigstens einer Stofflage mit einem Polymerisat umfaßt.

6. Verfahren nach Anspruch 5, dadurch gekennzeichnet, daß die Beschichtung durch wenigstens einmaliges Eintauchen des Stoffes in ein Bad aus einem Polymerisat in gesättigter Lösung in einem Lösungsmittel geschieht und daß in einer anschließenden Phase das Lösungsmittel verflüchtigt wird.

7. Verfahren nach Anspruch 5, dadurch gekennzeichnet, daß die Beschichtung warm erfolgt, durch Eintauchen des Stoffes in ein Bad aus geschmolzenem Polymerisat.

8. Verfahren nach einem der Ansprüche 5 bis 7, dadurch gekennzeichnet, daß es ferner einen Schritt umfaßt, durch den beabsichtigt ist, dem zwischen zwei Elektroden (5, 6) angeordneten Film aus zusammengesetztem Material piezoelektrische und pyroelektrische Eigenschaften zu verleihen, indem er während einer vorbestimmten Zeit einem elektrischen Feld ausgesetzt wird, wobei die Elektroden (5, 6) an einen elektrischen Energiegenerator (8) angelegt sind, der eine hohe Gleichspannung abgibt; wobei das Feld zu den Filmflächen senkrecht ist.

9. Verfahren nach Anspruch 8, dadurch gekennzeichnet, daß die elektrische Polarisation des Films aus zusammengesetzten Material mittels einer Corona-Entladung erhalten wird.

10. Verfahren nach Anspruch 8, dadurch gekennzeichnet, daß die elektrische Polarisation erhalten wird, indem durch Entladung unter niedrigem Druck ein Plasma (12) gebildet wird.

11. Verfahren nach einem der Ansprüche 8 bis 10, dadurch gekennzeichnet, daß wenigstens eine Elektrode eine durch eine leitfähige Flüssigkeit gebildete Elektrode ist.

FIG. 2

FIG.1

0 025 751

FIG.3

FIG.4

FIG.5

2